# EUROPÄISCHE PATENTANMELDUNG

(11) **EP 0 652 697 A1**
(43) Veröffentlichungstag der Anmeldung: **10.05.1995**
(21) Anmeldenummer: 94117267.8
(22) Anmeldetag: 02.11.1994
(51) Int. Cl.: H05K 13/00, G01R 31/28

(54) **Verfahren und Vorrichtung zum Temperieren und Prüfen von elektronischen, elektromechanischen und mechanischen Baugruppen**

(30) Priorität: 10.11.1993 DE 4338445
(71) Anmelder: Heraeus Industrietechnik GmbH, D-63450 Hanau (DE)
(72) Erfinder: Rasp, Richard Alexander, D-72336 Balingen (DE); Johannsen, Bernd, D-93057 Regensburg (DE)
(74) Vertreter: Stoffregen, Hans-Herbert, Dr. Dipl.-Phys.

(57) **Zusammenfassung**

Baugruppen - wie z.B. Leiterplatten - mit aufgebrachten elektronischen, elektromechanischen und mechanischen Bauelementen bzw. Einzel-Komponenten werden nach Aufbringung im Lötverfahren einer oder mehreren Prüfphasen bei Hoch- und Tieftemperatur unterzogen, um bei Auftreten von Fehlern gegebenenfalls sofortige Korrekturmaßnahmen ergreifen zu können; hierzu werden die Baugruppen in einer ersten Prüfphase unter Ausnutzung der Löttemperatur auf einer Temperatur im Bereich von 40 bis 125°C und in einer zweiten Prüfphase auf einer Temperatur im Bereich von -40 bis 10°C temperiert, wobei in der jeweiligen Prüfphase die Baugruppen einem Komponenten- und/oder Funktionstest zur Ermittlung defekter Baugruppen unterzogen werden; als einwandfrei ermittelte Baugruppen werden anschließend einer Ausgabe-Vorrichtung zugeführt, während defekte Baugruppen aus dem Weg zu Ausgabevorrichtung herausgeschleust werden und eine Fehlermeldung ausgegeben wird.

Zur verbesserten Fehlerkontrolle können die Baugruppen mit einer vor der jeweiligen Prüfphase einlesbaren digitalen Codierung versehen sein, so daß eine Verwaltung defekter und einwandfreier Baugruppen mittels Digitalrechner möglich ist.

## Beschreibung

Verfahren zum Temperieren und Prüfen von elektronischen, elektromechanischen oder mechanischen Baugruppen mit aufgebrachten Bauelementen als Halbzeug, insbesondere Leiterplatten, die aufeinanderfolgend eine Lötstation verlassen und nach Temperierung in einer Prüfphase mittels einer Adapter-Einheit mit wenigstens einer elektronischen Prüfvorrichtung elektrisch verbunden und durch diese geprüft werden, sowie eine Vorrichtung.

Aus der US-PS 48 18 933 ist ein System zur Handhabung und Prüfung von Leiterplatten mit aufgebrachten elektrischen bzw. elektronischen Bauelementen bekannt, wobei die Leiterplatten vor ihrem endgültigen Einbau in Geräte bezüglich der korrekten Positionierung und Orientierung der aufgebrachten Bauelemente sowie der Funktion geprüft werden; das System weist einen Trägerrahmen, welcher wenigstens eine Adapterplatte zur Kontaktierung von Leiterplattenkontakten enthält, und Ausrichtungs- sowie Verriegelungs- und Transportvorrich-tungen zur Zuführung und Abführung der zu prüfenden Leiterplatte auf. Wesentlich ist dabei, daß während des Prüfvorganges bereits eine nachfolgende Leiterplatte zugeführt und arretiert werden kann.

Weiterhin ist in der US-PS 50 55 779 ein integriertes Leiterplattenprüfsystem betrieben, beschrieben, bei dem auch die Umwandlung einer herkömmlichenen Vakuumtestvorrichtung in eine mechanische Testvorrichtung beschrieben ist. Als problematisch erweist sich der Einsatz solcher Prüfvorrichtungen bei Hochtemperatur bzw. Tieftemperaturprüfungen von Leiterplatten, da die zugehörige Prüfelektronik sich unmittelbar an die Adapter zur Abtastung der Prüfpunkte auf die Leiterplatinen anschließt und beispielsweise eine Umgebungstemperatur von 100°C, wie sie für einen Hochtemperaturtest für Leiterplatten erforderlich wäre, auch die Betriebstemperatur der Prüfvorrichtung erhöhen und damit möglicherweise deren ordnungsgemäßen Betrieb stören würde.

Aus dem DE-GM 83 04 116 ist ein Prüfschrank mit einer Kammer, in der Prüfungsplatinen für elektronische Bauelemente angeordnet sind, bekannt; darin soll festgestellt werden, ob die Prüfplatinen unter vorgegebenen Testbedingungen wie beispielsweise Temperaturen ausfallen oder nicht; unter Verwendung besonderer Abdichtungsmaßnahmen der Prüfkammern soll auf engstem Raum eine Vielzahl von elektrischen Kontakten zwischen Ansteuerplatine der Testvorrichtung und Prüfplatinen innerhalb des Schrankes hergestellt werden.

Weiterhin ist aus der DE-PS 37 21 653 ein Ofen mit einer Ofenkammer zum Testen von auf Leiterplatten angeordneten elektrischen Bauteilen bekannt, wobei in einem Wand-, Boden- oder Deckenteil ein oder mehrere Schlitze mit beidseitig der Längsseiten des Schlitzes befestigten temperaturbeständigen Dichtlippen vorgesehen sind, durch die Teile von Trägerplatten hindurchsteckbar sind. Die Dichtlippen sind dabei aus jeweils zwei schlauchförmigen Dichtprofilen eines beispielsweise U-förmigen Querschnitts gebildet, wobei die Profile in der Schlitzmitte flächig aufliegen.

Weiterhin ist aus der US-PS 46 07 220 eine Vorrichtung zum Testen von elektronischen Einzel-Komponenten, wie beispielsweise integrierten Schaltungen bekannt, bei denen die Testbedingungen in einem weiten Temperaturbereich von beispielsweise -65° bis +150°C durchgeführt werden.

Als problematisch erweist sich bei den bekannten Temperier- und Testvorrichtungen die chargenweise Bestückung der Öfen bzw. Schränke oder Testvorrichtungen, so daß zwischen den Fertigungsschritten oder Temperierphasen eine Funktionsprüfung nicht möglich ist und die Baugruppen erst nach ihrer Fertigstellung, d.h. kompletten Bestückung mit ihrer äußeren Anschlußkonfiguration endgültig getestet werden können.

Die Erfindung stellt sich die Aufgabe, Baugruppen mit aufgebrachten Bauelementen bzw. Einzel-Komponenten nach einem Lötverfahren jeweils mindestens einer Prüfphase bei Hoch- und/oder bei Tieftemperatur zu unterziehen, wobei ermittelte Baugruppen-Defekte sofortige Korrekturmaßnahmen auslösen sollen, um systematische Fehler in vorgeschalteten Fertigungsstufen so rasch zu beheben, daß größere Mengen defekter Baugruppen vermieden werden können.

Darüberhinaus soll die zugeführte Energie optimal ausgenutzt werden.

Weiterhin soll nach der Erfindung der Einsatz prozeßrechnergesteuerter Fertigungsmittel möglich sein, so daß eine weitgehende Automatisierbarkeit des Fertigungs- und Temperier/Prüfverfahrens der Elektronik-Leiterplatten erzielt werden kann. Weiterhin soll aufgrund der zwischen den einzelnen Fertigungsschritten durchgeführten thermischen Beanspruchungen mit anschließenden Funktionstest die dem jeweiligen Funktionstest vorgelagerte Fertigungsstufe im Hinblick auf ihre für die Zuverlässigkeit wirksamen Parameter überprüft werden, so daß sich eine rasche Korrektur der Fertigungsparameter und somit eine geringe Ausschußrate von Halbzeugen erzielen läßt.

Die Aufgabe wird verfahrensgemäß durch die kennzeichnenden Merkmale des Anspruchs 1 gelöst.

Ein wesentlicher Vorteil der Erfindung ist darin zu sehen, daß aufgrund der raschen Erkenntnis fehlerhafter Fertigungsschritte eine ständige Optimierung der Einzelkomponenten bzw. des gesamten Fertigungsablaufes möglich ist, wobei eine sofortige Aussortierung defekter Baugruppen mit anschließender Instandsetzung möglich ist. Darüberhinaus erweist es sich als vorteilhaft, ggf. gezielt die erkannten Fehler bzw. zu große Fehlertoleranzen zur Optimierung der Parameter vorgeschalteter Fertigungsstufen zu verwenden, wobei beispielsweise kalte Lötstellen oder fehlerhafte Ausrichtungen von Bauelementen durch eine erneute Zuführung eines fehlerhaften Halbzeuges bereinigt werden können.

Weitere vorteilhafte Ausgestaltungen des Verfahrens gemäß Anspruch 1 sind den Ansprüchen 2 bis 13 zu entnehmen.

Die Aufgabe wird vorrichtungsgemäß durch die kennzeichnenden Merkmale des Anspruchs 14 gelöst.

In einer vorteilhaften Ausgestaltung ist die Vorrichtung modulartig aufgebaut, so daß ein rascher Austausch bzw. Ersatz von einzelnen Modulen möglich ist; in einer weiteren Ausgestaltung ist es möglich, die Transportvorrichtung in Vorrichtungsmodule bzw. Einzelmodule mit Einzelantrieb zu unterteilen.

Weitere vorteilhafte Ausgestaltungen der Vorrichtung sind in den Ansprüchen 14 bis 18 angegeben.

Bei der erfindungsgemäßen Vorrichtung erweist es sich durch den modulartigen Aufbau als vorteilhaft, daß eine Aufteilung des Fertigungsprozesses in mehrere Einzelschritte möglich ist, wobei durch funktionelles Zusammenwirken an sich getrennter Systeme innerhalb eines geschlossenen Systems unter anderem eine Energieersparnis erzielt werden kann.

Ein weiterer Vorteil ist darin zu sehen, daß ein schematisch vorgegebener Verfahrensablauf auf einfache Weise dadurch abgeändert werden kann, daß aus der modulartig aufgebauten Vorrichtung Einzelmodule entnommen und ausgetauscht bzw. durch andere Module ersetzt werden können; durch leichte Zugänglichkeit der einzelnen Module und der darin befindlichen Vorrichtung wird die Servicefreundlichkeit stark verbessert; die Verfügbarkeit der Vorrichtung wird dadurch gesteigert.

Ein weiterer Vorteil ist in der Automatisierbarkeit durch Einsatz kodierter Baugruppen sowie von Dekodierungseinrichtungen innerhalb der Vorrichtung zu sehen, da mit Hilfe eines zentralen Rechners auf diese Weise eine verhältnismäßig übersichtliche Baugruppenverwaltung sowie eine automatisierbare Qualitätskontrolle möglich ist und eine Traceability im Sinne der Qualitätsnorm (ISO 900) gegeben ist. Ein weiterer Vorteil ist darin zu sehen, daß durch Wärmekonvektion die Leiterplatten nach Verlassen der Lötvorrichtung in der Prüfphase 1 stets mit allen Komponenten auf dem gleichen Temperaturniveau gehalten und genutzt werden können.

Ein weiterer Vorteil ist darin zu sehen, daß die Transportvorrichtung in ihren Vorrichtungsmodulen bzw. Einzelmodulen für den Baugruppen-Transport mit kontinuierlicher oder getakteter Bewegung oder auch in kombinierter Form, gegebenenfalls mit zusätzlicher Beschleunigung betrieben werden kann, um Leerlauf-Bewegungen zwecks Energieersparnis zu vermeiden und die Zuverlässigkeit zu erhöhen; zusätzlich wird die Durchlaufzeit der Baugruppe reduziert.

Weiterhin ist es möglich, mittels Zentralrechner eine automatisierbare Breitenverstellung und gegebenenfalls eine Mittenunterstützung der Transportrahmen vorzusehen, so daß ein flexibles Produktionsprogramm verschieden formatierter Baugruppen bzw. Leiterplatten die erfindungsgemäße Vorrichtung durchlaufen kann.

Im folgenden ist der Gegenstand der Erfindung anhand der Figuren 1a, 1b, 2, 3a bis 3f, 4 und 5 näher erläutert.
- Figur 1a: zeigt schematisch eine Draufsicht auf die erfindungsgemäße Vorrichtung zusammen mit einer vorgeschalteten Bestückungsvorrichtung und Lötstation, die beide symbolisch dargestellt sind während Figur 1b Temperaturprofil der Baugruppe gemäß Figur 1a entlang der Transportachse X zeigt.
- Figur 2: zeigt im Flußdiagramm die Ablaufsteuerung für eine durch die Vorrichtung geführte Baugruppe.
- Figur 3a: zeigt eine ausschnittsweise Draufsicht auf die Vorrichtung, wobei diese für in ihrer Breite verstellbare Baugruppen bzw. Leiterplatten geeignet ist.
- Figur 3b: zeigt schematisch eine Vorderansicht der Vorrichtung gemäß Figur 3a, wobei die Figuren 3c bis 3f Schnitte an verschiedenen Stellen gemäß Figur 3 b wiedergeben.
- Die Figuren 4a und 4b: zeigen im Längsschnitt und im Querschnitt jeweils eine Prüfzone mit Prüfvorrichtung und dem zugehörigen Adapter.
- Figur 5: zeigt ausschnittsweise einen Adapter, dessen Tastelemente sowohl zur Kontaktierung oberhalb als auch unterhalb der Baugruppe vorgesehen sind.

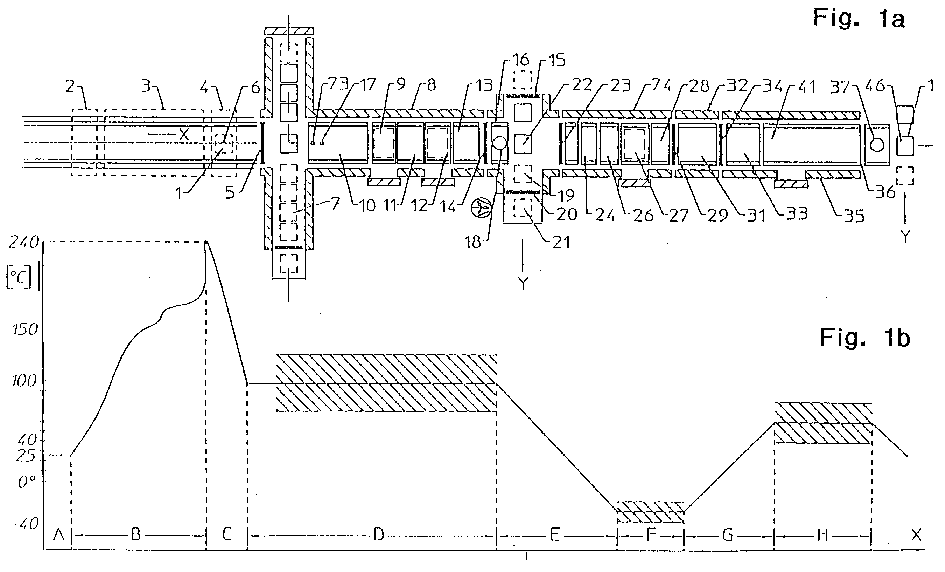

Gemäß Figur 1a und 1b verläßt die hier als Baugruppe 1 schematisch dargestellte Leiterplatte die symbolisch dargestellte Bestückungsvorrichtung 2 entlang der Transportrichtung X, und wird nachfolgend der ebenfalls symbolisch dargestellten Lötstation 3 zugeführt, in welcher gemäß Figur 1b die Temperatur auf einen Wert bis über 240°C gebracht wird, um eine ordnungsgemäße Verlötung der Leiterplatte als Baugruppe mit den aufgesetzten Bauelementen zu erzielen. Nach Verlassen der Lötstation 3 wird in einer Temperierzone 4 die Temperatur der Leiterplatte 1 auf eine Temperatur im Bereich 70 bis 125°C gebracht. Die Leiterplatte verläßt die Temperierzone 4 durch das verschließbare Gatter 5 und tritt mittels Transportvorrichtung 6 über Pufferbereich 7 in die erste Prüfzone 8 ein; Pufferbereich 7 dient der Entkopplung zwischen der Lötstation und dem Eintrittsbereich der ersten Prüfzone 8, wobei auch ggf. reparierte Leiterplatten über den Pufferbereich zwecks Durchlaufen des Prüfungsverfahren zugeführt werden können. Die Prüfzone 8 sowie der vorgeschaltete Pufferbereich 7 enthalten eine Atmosphäre im Temperaturbereich von 70 bis 125°C, wobei die Innenatmosphäre durch eine thermische Isolation gegenüber der Außenatmosphäre abgeschirmt wird; vorzugsweise besteht die Innenatmosphäre der ersten Prüfzone 8 aus Luft, wobei der eingestellte Temperaturwert im Bereich von 60 bis 130°C als Sollwert vorgegeben wird; es ist jedoch auch möglich, Inertgas - wie beispielsweise Stickstoff - einzusetzen. Die erste Prüfzone 8 ist thermisch und atmosphärisch zumindest weitgehend gegenüber der Umgebung abgeschlossen. Die Prüfzone 8 ist in Form eines Durchlauftunnels gestaltet, wobei zum Abtransport von Baugruppen aus dem Pufferbereich 7 in die erste Prüfstation 9 ein schnellaufendes Bandtransportelement 10 der Transportvorrichtung 6 vorgesehen ist; die Transportvorrichtung 6 ist in Vorrichtungsmodule aufgeteilt, welche wiederum in Einzelmodule, beispielsweise in Bandtransportelemente aufgeteilt sein können; die Transportbewegung kann entweder kontinuierlich, getaktet oder in kombinierter Form gegebenenfalls mit kontinuierlicher Beschleunigung betrieben werden. Im Bereich des Bandtransportelements 10 ist ein Lagekennungssystem 73 und ein Abtastsystem 17 angeordnet, das zur Identifikation, Registrierung und Lagerkennung der zugeführten Baugruppen dient, die ihrerseits mit einem abtastbaren Code versehen sind. Ein weiteres schnelles Bandtransportelement 11 ist zur Weiterleitung der Baugruppen aus der ersten Prüfstation 9 in die zweite Prüfstation 12 vorgesehen. Zum Abtransport der Baugruppen aus Prüfstation 12 dient ein weiteres Bandtransportelement 13, das zur Abführung der Baugruppen aus der ersten Prüfzone 8 durch Gatter 14 dient. An Gatter 14 schließt sich ein zweiter Pufferbereich 15 an, der sich in Verbindung mit der Umgebungsatmosphäre befindet und somit zur Abkühlung der Baugruppen nach Verlassen der ersten Prüfzone 8 dient.

Wie im Bereich des ersten Bandtransportelements 10 ist auch im Bereich des sich an Gatter 14 anschließenden weiteren Bandtransportelements 16 ein Abtastsystem 18 angeordnet, um die Baugruppe nach der Prüfung in Prüfzone 8 zwecks Weiterbehandlung in Abhängigkeit vom Prüfungsergebnis zu steuern. Die Registrier- und Steuervorgänge werden in einem Zentralrechner durchgeführt, welcher mit den Abtastsystemen und den Prüfeinrichtungen sowie den Steuereinrichtungen für die Transportvorrichtung 6 und für die Gatter verbunden ist. Im zweiten Pufferbereich 15 ist neben der in X-Richtung führenden Transportvorrichtung 6 eine hierzu senkrecht verlaufende Schleusentransportvorrichtung 19 vorgesehen, welche über Gatter 20 defekte Baugruppen, die hier symbolisch mit Bezugziffer 21 bezeichnet sind, aus dem zweiten Pufferbereich 15 in Y-Richtung zwecks Entnahme herausschleust.

Der Weitertransport von als einwandfrei ermittelten Baugruppen 22 erfolgt mittels Transportvorrichtung 6 über Gatter 23 in die zweite Prüfzone 74, welche zum Tieftemperaturtest der Baugruppen dient und ebenso wie die erste Prüfzone gegenüber der Außenatmosphäre thermisch weitgehend isoliert ist. An Gatter 23 schließt sich ein Bandtransportelement 24 an, das in ein Schnellauf-, ein Langsamlauf- und Schnellauf-Segment unterteilt ist, wobei im Bereich des Bandtransports 24 ein Trockenluft- bzw. Trockengaszutritt 26 angeordnet ist, durch den eventuelle Kondensationsfeuchte von den Baugruppen entfernt werden kann. An das Bandtransportelement schließt sich die dritte Prüfstation 27 an, welche ebenso wie die Prüfstation der ersten Prüfzone mit einem Adapter zur Kontaktierung der zu prüfenden Baugruppe ausgestattet ist. An Prüfstation 27 schließt sich ein weiteres Bandtransportelement 28 der Transportvorrichtung 6 an, welches die Baugruppe in Transportrichtung X zu dem die zweite Prüfzone begrenzenden Gatter 29 führt, von wo es nach Passieren des geöffneten Gatters in eine Klimatisierungs- oder Aufwärmzone 31 geführt wird, die ebenfalls mit einem Trockenluft- bzw. Trockengaszutritt 32 versehen ist. Nach Durchlaufen der Klimatisierungszone 31 wird die Baugruppe mittels Bandtransportelement 33 durch Gatter 34 in eine Erwärmungs- bzw.Ausgabevorrichtung 35 geführt, an deren Ende 36 ein weiteres Abtastsystem 37 vorhanden ist, welche die als einwandfrei ermittelten Baugruppen in X-Richtung zur Weiterverarbeitung transportiert, während die als defekt erkannten Baugruppen in Y-Richtung ausgeschleust werden.

Das Temperaturprofil gemäß Figur 1b wird nachfolgend anhand der Funktionsbeschreibung erläutert; das Temperaturprofil ist entsprechend der Transportvorrichtung X der Figur 1a in Temperatur-Intervalle A, B, C, D, E, F, G und H aufgeteilt.

Intervall A stellt gemäß Fig. 1b die Temperatur in der gemäß Figur 1a nur schematisch dargestellten Bestückungsvorrichtung 2 dar, während die daran angrenzende Temperaturerhöhung im Intervall B den Temperaturverlauf entlang der Transportrichtung, d. h. der X-Achse in der schematisch dargestellten Reflow-Lötstation 3 wiedergibt. Nach Verlassen der Lötstation durchläuft die hier schematisch mit Bezugsziffer 40 versehene Baugruppe die Abkühlungszone 4, in der gemäß dem Intervall C die Temperatur von etwa 240°C auf 100°C herabgesetzt wird, so daß beim Eintritt der Baugruppe 40 in die erste Prüfstation 9 durch Gatter 5 die Baugruppe ein verhältnismäßig hohes Temperaturniveau gegenüber der Umgebung mitbringt, so daß innerhalb des Pufferbereichs 7 und der sich daran anschließenden ersten Prüfzone 8 nur eine geringe Energiezufuhr für Regelungszwecke erforderlich ist. Innerhalb der durch Pufferbereich 7 und erste Prüfzone 8 gebildeten thermisch isolierten Zone kann der Temperatursollwert im Bereich von 25 bis 200°C - vorzugsweise von +60 bis +130°C - eingestellt werden. Dabei ist es möglich, diesem durch Pufferstation und Prüfzone gebildeten Temperierbereich Inertgas, beispielsweise Stickstoff, zuzuführen, um Korrosionen der Baugruppe bzw. der aufgebrachten Bauelemente oder ihrer Kontakte mit Sicherheit zu verhindern. Nach Verlassen des Pufferbereichs 7 durchläuft die Baugruppe mittels Bandtransportelement 10 das Abtastsystem 17, welches anhand eines auf der Baugruppe befindlichen Codes die Art und Werksnummer der eingelaufenen Baugruppe registriert und das bzw. die zu erwartenden Prüfungsergebnisse der entsprechenden Werksnummer zuordnet. In der ersten Prüfstation 9 wird die Baugruppe einem Komponenten- oder Incircuit-Test unterworfen, wobei die aufgebrachten Einzelkomponenten und die Leiterbahnen der Baugruppe geprüft werden. Nach Abschluß des Incircuit-Tests wird das Prüfungsergebnis der dekodierten Werksnummer zugeordnet, wobei eine defekte Baugruppe mittels der Bandtransportelemente 11 und 13 ohne weitere Prüfung aus der Prüfzone 8 in den zweiten Pufferbereich 15 zwecks Ausschleusung geführt wird, während eine sich bis dahin als einwandfrei erwiesene Baugruppe mittels Bandtransportelement 11 der zweiten Prüfstation 12 zur Durchführung eines Funktionstests der Gesamtleiterplatte zugeführt wird. Eine als defekt ermittelte Baugruppe wird wiederum über Bandtransportelement 13 und Gatter 14 zwecks Aussortierung dem Pufferbereich 15 zugeführt, wobei das Ausschleusungssignal der an der Dekodiereinrichtung 18 des Pufferbereichs ermittelten Werksnummer zugeordnet wird und die defekte Baugruppe quer zur Transport-Richtung den Pufferbereich 15 zwecks Ausschleusung verläßt; eine als einwandfrei erkannte Baugruppe wird nach Durchlaufen der Dekodiereinrichtung im Pufferbereich 15 gemäß dem Temperaturprofil des Intervalls E auf Raumtemperatur abgekühlt, wobei eine als einwandfrei ermittelte Baugruppe über Gatter 23, Bandtransportelement 24 der dritten Prüfstation 27 zur weiteren Funktionsprüfung unter Tieftemperaturbedingungen zugeführt wird. Der zugehörige Temperaturverlauf mit dem Abstieg von ca. 100° auf ca. -40°C und Aufrechterhaltung ist in den Intervallen E und F dargestellt. Nach Verlassen der Prüfstation 27 wird die Baugruppe mittels Bandtransportelement 28 durch Gatter 29 aus der zweiten Prüfzone in die Klimatisierungszone 31 herausgeführt, wobei die auf Bandtransportelement 33 transportierte Baugruppe durch Trockenluft bzw. Gaszutritt 32 erwärmt wird, wobei gemäß Intervall G der Figur 1b die Temperatur über die Raumtemperatur auf ca. 40° ansteigt, und dieser Temperaturzustand in der Warmbehandlungsphase der Warmkammer 41 aufrechterhalten wird, bis sämtliche Feuchtigkeit bzw. Kondensationsfeuchtigkeit abgedampft ist; dieses Intervall wird mit dem Buchstaben H bezeichnet. Nach Verlassen der Warmkammer 41 wird die Baugruppe auf dem Ausgabetransportelement 42 weiterhin in X-Richtung transportiert und mittels Dekodiervorrichtung 43 erfaßt; bei einwandfrei ermittelten Baugruppen erfolgt ein weiterer Transport in die nachfolgende Fertigungsstufe bzw. Lagerung; falls jedoch ein Baugruppendefekt vorliegt, wird die als defekt ermittelte Baugruppe in Richtung Y aus der Ausgabevorrichtung 46 herausgeschleust, wobei der Abtransport entsprechend den in Pufferbereich 7 bzw. Pufferbereich 15 erläuterten Maßnahmen erfolgt.

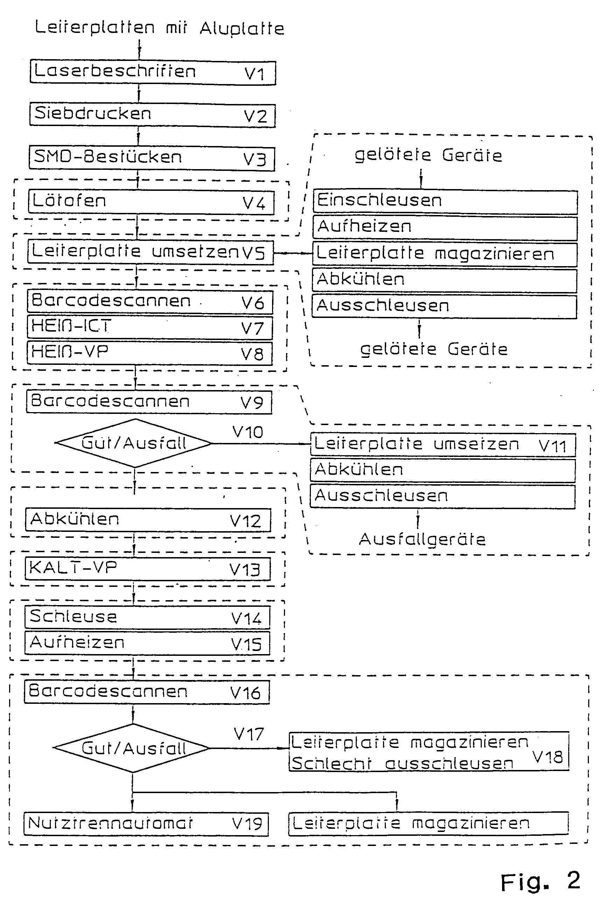

Figur 2 zeigt im Flußdiagramm die Ablaufsteuerung der Baugruppe im erfindungsgemäßen Verfahren, wobei die Verfahrensschritte V1 - V3, wie Laserbeschriften, Siebdrucken und SMD-Bestücken nicht zum eigentlichen Gegenstand des Verfahrens gehören, jedoch der besseren Verständlichkeit halber aufgenommen sind.

Gemäß Figur 2 werden die Baugruppen beispielsweise mit rückseitiger Aluminiumplatte oder Keramikplatte im Verfahrensschritt V1 durch Laserbeschriften gekennzeichnet, wobei beispielsweise auch ein optisch lesbarer Balkencode aufgetragen wird, um eine eindeutige Zuordnung der Baugruppe durch optische Abtastung und deren Verwaltung bzw. Registrierung mittels Rechnersystem zu ermöglichen; weiterhin werden die Konfigurationen der Kontaktfelder und Leiterbahnen im Verfahrensschritt V2 beispielsweise im Siebdruck aufgebracht und im Verfahrensschritt V3 eine Bestückung mit elektronischen, elektromechanischen oder mechanischen Komponenten vorgenommen. Im Verfahrensschritt V4 erfolgt eine elektrische und mechanische Verbindung der aufgesetzten Komponenten beispielsweise durch Verlöten in der Lötstation, wobei anschließend in Verfahrensschritt V5 die Leiterplatte temperiert wird, um eine vorgegebene Prüftemperatur zu erhalten.

Anschließend erfolgt im Verfahrensschritt V6 eine optische Abtastung der zugeführten Baugruppe mittels Barcodescannen, während im Verfahrensschritt V7 eine Hochtemperaturkomponenten bzw. In-Circuit-Prüfung erfolgt und im Verfahrensschritt V8 eine Hochtemperaturfunktionsprüfung sich anschließt. Der jeweils im Schritt V6 ermittelten und gespeicherten Baugruppencodierung wird das in den Verfahrensschritten V7 bzw. V8 ermittelte Prüfungsergebnis zugeordnet, wobei ein in den Schritten V7 oder V8 ermitteltes schlechtes Prüfungsergebnis zu einer Belegung der vorher in Schritt V6 ermittelten Nummer mit dem Symbol "defekt" erfolgt und die Baugruppe nach Ermittlung ihrer Codierung im Verfahrensschritt V9 dem Prüfungsergebnis entsprechend im Verfahrensschritt V10 dem Verfahrensschritt V11 zwecks Ausschleusung zugeführt oder bei ordnungsgemäßem Prüfungsergebnis dem Verfahrensschritt V12 zwecks Abkühlung mit anschließender Kalttemperaturprüfung im Verfahrensschritt V13 zugeführt wird. Anschließend wird die Baugruppe über eine Schleuse im Verfahrensschritt V14 weitertransportiert. Im Verfahrensschritt V15 wird die Baugruppe wieder aufgeheizt, um Kondensationsfeuchtigkeit nach dem Abkühlungsvorgang abdampfen zu lassen; im Verfahrensschritt V16 wird eine erneute Auslesung der Baugruppencodierung vorgenommen und die Baugruppennummer dem im Verfahrensschritt V13 ermittelten Prüfungsergebnis des Kältetests zuzuordnen. Im Verfahrensschritt V17 wird entschieden, ob die Baugruppe aufgrund eines Baugruppendefekts im Verfahrensschritt 18 als defekt ausgeschleust oder im Verfahrensschritt V19 als ordnungsgemäß geprüfte Baugruppe zur Weiterverarbeitung oder Magazinierung ausgegeben wird.

Gemäß Figur 3a ist der modulare Aufbau der Vorrichtung erkennbar, wobei zwecks besserer Übersicht die als Module aufgebauten einzelnen Stationen durchgängig mit den Bezeichnungen S1 bis S14 versehen sind; Vorrichtungselemente, die bereits anhand der Figur 1a erläutert sind, werden ergänzend mit den aus dieser Figur bekannten Bezeichnungen versehen.

Gemäß Figur 3a gelangen die Baugruppen nach Verlassen der Lötstation S1 in die erste Temperierzone 4, in welcher sich die Vereinzelungsstation S2, die Puffer-Station S3, die Abtaststation S4, die erste Prüfstation S5 sowie die reservierte Strecke S6für die Weichenstellung zur Ausschleusung defekter Baugruppen S6 und die zweite Prüfstation S7 befinden. Wie bereits eingangs erläutert, ist die Temperatur in dieser ersten Temperierzone in einem Bereich zwischen 25 bis 200°C einstellbar.

Nach Verlassen der Station S7 gelangen sämtliche Baugruppen in einen ungeregelten Temperaturbereich, wobei defekte Baugruppen über Ausschleusungsstation S8 aus dem Prüfverfahren aussortiert werden, während als einwandfrei getestete Baugruppen der zweiten Temperierzone mit der Kaltprofileinheit S9 zugeführt werden; in diesem zweiten Temperierbereich werden die Baugruppen auf eine vorgegebene Temperatur im Bereich von -50 bis +25°C eingestellt. Sie werden dabei entlang der mit X bezeichneten Richtung der dritten Prüfstation (Inline-Test) S10 zugeführt und verlassen die zweite Temperierzone über die als Kalt-Warm-Schleuse ausgebildete Station S11 und treten in einen ungeregelten Temperaturbereich ein. Um Kondenswasserbildung bei Raumtemperatur zu verhindern, werden die Baugruppen weiterhin einer dritten Temperierzone mit der Station Warm-Profil S12 zugeführt, wobei die als nicht einwandfrei ermittelten Baugruppen über die zweite Ausschleusungs-Station S13 aus dem zur Ausgabevorrichtung S14 führenden Weg aussortiert werden.

Gemäß der Draufsicht in Figur 3a ist es auch möglich, Baugruppen verschiedener Formate zu behandeln, wobei die variable Breite und eventuelle Mittenunterstützung der Baugruppen durch maschinelle oder manuelle Verstellung der Ketten bzw. Bandantriebe erfolgt; gemäß Figur 3a sind in Transportrichtung X gesehen die rechtsseitigen Band- bzw. Kettenantriebe stationär angeordnet, während die linksseitigen Kettenantriebs- bzw. Bandantriebselemente und gegebenenfalls eine Mittenunterstützung für die Baugruppen in Richtung der symbolisch eingetragenen Y-Achse verschiebbar angeordnet sind. Anhand der Figur 3a ist zunächst der Pufferbereich 7 erkennbar, wie er bereits anhand der Figur 1 erläutert wurde, der zusammen mit der ersten Prüfzone 8 ein thermisch und ggf. atmosphärisch gegenüber der Umgebung weitgehend abgeschlossenes isoliertes System bildet; die aus der Lötanlage kommenden Baugruppen treten nach einer Abkühlungsphase durch Gatter 5 in den Pufferbereich 7 der zusammen mit der ersten Prüfzone 8 ein geschlossenes thermisches System bildet, wobei die Baugruppen nach Verlassen des Pufferbereichs 7 ein Abtastsystem zur Ermittlung und Registrierung der jeweiligen Leiterplatte durchlaufen und anschließend die erste Prüfstation 9 zwecks Komponententest und die zweite Prüfstation 12 zwecks Funktionstest durchlaufen; die Prüfungsergebnisse werden - wie bereits oben ausgeführt - den jeweils ermittelten Baugruppennummern zugeordnet, wobei defekte Baugruppen nach Verlassen der ersten Prüfzone über Gatter 14 dem zweiten Pufferbereich 15 zugeführt werden, wobei die in den Prüfstationen 9 und 12 erzielten Prüfungsergebnisse den jeweiligen Baugruppennummern zugeordnet und defekte Baugruppen im zweiten Pufferbereich 15 ausgeschleust werden; die als ordnungsgemäß ermittelten Baugruppen werden in Transportrichtung X der zweiten Prüfzone mit der dritten Prüfstation 27 zugeführt, wobei diese zwecks Kältetest gegenüber der Umgebung thermisch abgeschlossen und die Baugruppe lediglich über Gatter 29 zuführbar bzw. Gatter 34 herausführbar sind.

Gemäß der in Figur 3a beschriebenen Vorrichtung ist es auch möglich, die Baugruppenformate im Abtastsystem zu entschlüsseln und eine entsprechende Breitenverstellung der Baugruppen mittels Zentralrechner und entsprechender Stellelemente für die Breitenverstellung der Transportbänder bzw. Transportketten und ggf. einer Mittenunterstützung automatisch oder manuell vorzunehmen, sofern aus der Codierung die Formatierung der Baugruppen erkennbar ist.

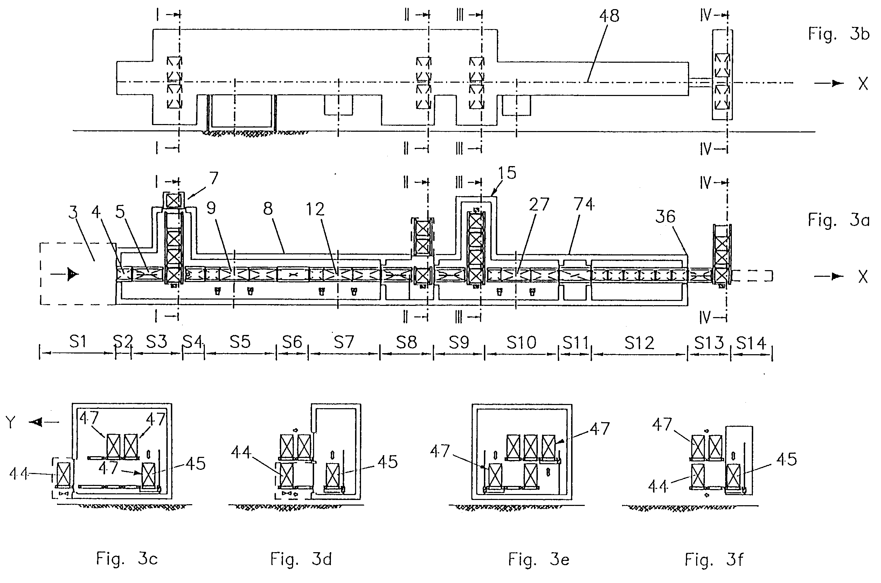

Figur 3b zeigt im Profil die Baugruppentransportebene 48 sowie die zugehörigen Pufferbereiche und Prüfstationen entlang der Transportrichtung X. Weiterhin sind in Figur 3b die Schnitte I-I, II-II, III-III und IV-IV erkennbar, die jeweils in den Schnittfiguren 3c, 3d, 3e und 3f dargestellt sind. Anhand der Figur 3c ist erkennbar, daß sich die Baugruppe 45 in einem Magazin 47 befindet, das mit seiner rechten Seitenkante im Anschlag bzw. auf der rechten Transportkette bzw. dem rechten Transportband steht, während der linke Teil der Baugruppe sich in einem Magazin 47 auf einer in Y-Richtung variabel einstellbaren Transportkette oder Transportband befindet. Mittels der Baugruppe 44 ist die Zufuhr bzw. Abführung defekter Baugruppen symbolisch dargestellt, im oberen Teil der Figur 3c sind leere Magazine 47 gezeigt, die im Falle einer Störung nachfolgende Baugruppen aufnehmen. Die Figur 3d zeigt eine mögliche Anordnung von Baugruppen 45 im zweiten Pufferbereich mit Ausschleusungsmöglichkeit defekter Baugruppen, während die Figur 3e schematisch einen Querschnitt durch die Baugruppenanordnung mit Baugruppen- bzw. Magazin-Umlauf zwecks Temperierung im Bereich der zweiten Prüfzone 74 darstellt.

Figur 3f zeigt im Querschnitt ähnlich wie Figur 3d eine mögliche Anordnung von Baugruppen mit Ausschleusungsmöglichkeit defekter Baugruppen.

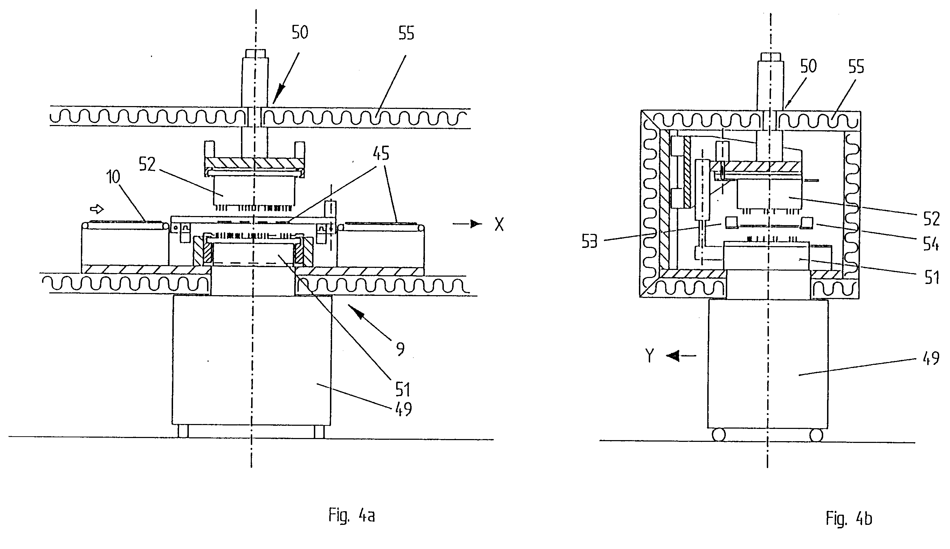

Figur 4a zeigt die Prüfstation im Längsschnitt entlang der X-Achse, während Figur 4b einen Querschnitt entlang der Y-Achse darstellt, wobei die Verstellbarkeit des Baugruppenadapters entsprechend der Plattenbreite erkennbar ist.

Gemäß Figur 4a werden die Baugruppen 45 mittels Bandtransportelement 10 der Prüfstation zugeführt, wobei die Baugruppe 45 von einem oberen Adapter 52 und einem unteren Adapter 51 kontaktiert wird, welche beide in einer der thermisch isolierten ersten bzw. zweiten Prüfzone angeordnet sind. Der untere Adapter 51 steht mit der ersten Prüfvorrichtung 49 über eine Thermobarriere 68 bzw. Thermotransferzwischenlage elektrisch und mechanisch in Verbindung, so daß die thermische Isolation des von Pufferbereich und erster Prüfzone gebildeten atmosphärischen Bereichs gegenüber der Außenumgebung weitgehend abgschlossen ist. Auch der oberhalb der Baugruppe 45 befindliche obere Adapter 52 ist mit Ausnahme seiner thermisch isolierenden Durchführung 50 durch die Isolationsschicht 55 der ersten Prüfzone geführt.

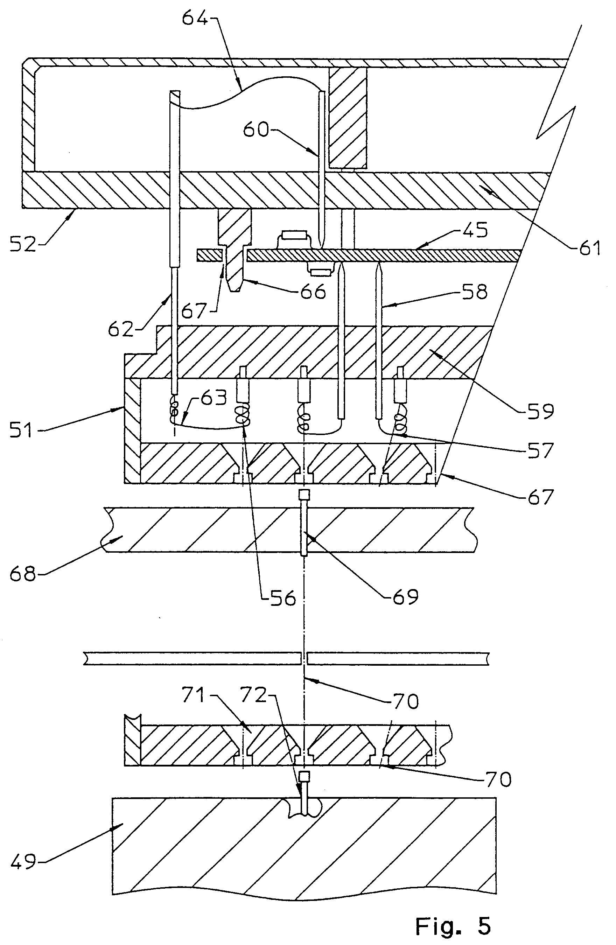

Ein entsprechender Aufbau ist im Querschnitt in Figur 4b dargestellt, wobei auch die für unterschiedliche Baugruppenformate erforderliche Breitenverstellung berücksichtigt ist. Gemäß Figur 4b ist sowohl der linke Teil 53 mit seinem Bandtransport- bzw. Kettentransport in Y-Richtung verstellbar, während der rechte Teil 54 des Bandtransports bzw. Kettentransports fest eingebaut ist. Aufbau und Funktionsweise der Adapter 51 und 52 entsprechen im wesentlichen den aus der Literatur bekannten Anordnungen, wie sie beispielsweise in der US-PS 48 18 933 beschrieben sind. Eine Besonderheit ist jedoch darin zu sehen, daß aufgrund der thermischen Isolation von erster und zweiter Prüfzone auch der untere Adapter 51 gegenüber der mit Raumtemperatur arbeitenden Prüfvorrichtung 49 durch eine Thermobarriere thermisch weitgehend isoliert ist. Der Aufbau einer solchen Thermobarriere ist anhand der Adaptereinrichtung, wie sie in Figur 5 auszugsweise dargestellt ist, näher erläutert.

Gemäß Figur 5 ist der untere Adapter 51 mit rasterförmig angeordneten Aufnahmebuchsen 56 versehen, in denen wenigstens teilweise Kontaktelemente 57 angeordnet sind, die elektrisch mit Prüfstiften 58 verbunden sind, welche durch die elektrisch isolierende untere Adapterplatte 59 geführt sind. Eine entsprechende Prüfstiftanordnung kann auch am oberen Adapter 52 angeordnet sein, wobei der Prüstift 60 des oberen Adapters durch die untere Adapterplatte 61 des oberen Adapters geführt sind. Eine übertragung der elektrischen Verbindung zu den oberen Prüfstiften 60 erfolgt über Kontaktelemente 57, deren Verbindung 63 zum Transferprobenstift 62 sowie einer Drahtverbindung 64 zum Prüfstift 60. Eine exakte Zuordnung der Kontaktpositionen der Baugruppe 45 mit den Positionen der Prüfstifte erfolgt mit Hilfe eines Justierstiftes 66, welcher in eine Ausnehmung 67 der Baugruppe 45 eingreift. Diese Vorrichtung ist im Prinzip aus der US-PS 48 18 933 bekannt, so daß im Hinblick auf die Adapter sowie die Baugruppe sich weitere Erläuterungen erübrigen. Wesentlich ist jedoch im Zusammenhang mit der Hochtemperaturprüfung in der ersten Prüfzone bzw. der Tieftemperaturprüfung in der zweiten Prüfzone, daß eine thermische Entkopplung zwischen den im jeweiligen Prüfzonenbereich befindlichen thermisch belastbaren Adaptern und der zugehörigen Prüfvorrichtung 49 möglich ist; hierzu dient eine zwischen der Rasterplatte 67 des unteren Adapters 51 und einer oberhalb der Prüfvorrichtung 49 befindlichen Rasterplatte angeordneten Thermobarriere 68, welche aus thermisch isolierendem Material besteht und aufgrund eines ausreichenden Abstandes zwischen Prüfstation und Adapter einen geringen Wärmedurchfluß ermöglicht. Der Anschluß der Rasterplatte 67 an die Prüfvorrichtung erfolgt durch die aus der Thermobarriere 68 herausragende Stifte 69, die über flexible Leiter bzw. Drähte 70 mit Aufnahmebuchsen 71 einer unteren, die Thermobarriere begrenzenden Rasterplatte verbunden sind, in welche aus der Prüfstation ragende Stifte 72 zwecks Kontaktierung hineinragen.

Es ist somit gewährleistet, daß eine im Raumtemperaturbereich funktionierende Prüfstation, wie sie beispielsweise aus der US-PS 48 18 933 bekannt ist, mit geringfügiger Modifikation zwecks Erstellung einer Thermobarriere auch beim Gegenstand der Erfindung verwendet werden kann.

## Patentansprüche

1. Verfahren zum Temperieren und Prüfen von elektronischen, elektromechanischen oder mechanischen Baugruppen, mit aufgebrachten Bauelementen als Halbzeug, insbesondere Leiterplatten, die aufeinanderfolgend eine Lötstation verlassen und nach Temperierung in einer Prüfphase mittels einer Adapter-Einheit mit wenigstens einer elektronischen Prüfvorrichtung elektrisch verbunden und durch diese geprüft werden, dadurch gekennzeichnet, daß jede der Baugruppen jeweils nach dem Lötvorgang vor einer ersten Prüfphase auf eine vorgegebene Temperatur im Bereich von -50 bis 200° temperiert und unter Aufrechterhaltung dieser Temperatur einem Komponenten- und/oder Funktions-Test zwecks Ermittlung defekter Baugruppen unterzogen wird, daß die in der ersten Prüfphase als einwandfrei erkannte Baugruppen nachfolgend in einer zweiten Prüfphase einer Temperierung im Temperaturbereich von -50 bis 200°C ausgesetzt und einem weiteren Komponenten- und/oder Funktions-Test zur Ermittlung defekter Baugruppen unterzogen werden, wobei die als einwandfrei ermittelten Baugruppen einer Ausgabe-Vorrichtung zugeführt werden, während bei Ermittlung von Baugruppen-Defekten die jeweils betroffene Baugruppe nach Lösung von der Adaptereinheit aus dem Weg zur Ausgabevorrichtung herausgeschleust und eine Fehlermeldung ausgegeben wird.

2. Verfahren nach Anspruch 1 , dadurch gekennzeichnet, daß in der ersten und/oder zweiten Prüfphase die Baugruppen auf eine vorgegebene Temperatur im Bereich von -50 bis 200°C temperiert werden.

3. Verfahren nach Anspruch 1 oder 2, dadurch gekennzeichnet, daß in der ersten Prüfphase die Baugruppen auf eine vorgegebene Temperatur im Bereich von 25 bis 200°C temperiert werden.

4. Verfahren nach Anspruch 1 oder 2, dadurch gekennzeichnet, daß in der zweiten Prüfphase die Baugruppen auf eine vorgegebene Temperatur im Bereich von -50 bis +25°C temperiert werden.

5. Verfahren nach einem der Ansprüche 1 bis 4, dadurch gekennzeichnet, daß die Temperierung der Baugruppen auf eine vorgegebene Temperatur mittels Sollwertvorgabe an einer Regeleinrichtung erfolgt, wobei eine maximale räumliche und zeitliche Regelabweichung in einem Toleranzbereich von maximal ± 5 K erzielt wird.

6. Verfahren nach einem der Ansprüche 1 bis 5, dadurch gekennzeichnet, daß bei Überschreiten einer vorgegebenen Anzahl defekter Baugruppen in einem definierten Zeitintervall die Bearbeitung von Baugruppen, die sich vor der Prüfvorrichtung befinden, unterbrochen wird.

7. Verfahren nach einem der Ansprüche 1 bis 6, dadurch gekennzeichnet, daß aufgrund der Fehlermeldung wenigstens ein Stellsignal zur Korrektur wenigstens eines Verfahrensparameters der der Prüfung vorgeschalteter Bearbeitungsschritte ausgegeben wird.

8. Verfahren nach einem der Ansprüche 1 bis 7, dadurch gekennzeichnet, daß die jeweilige Baugruppe in ihrer ersten Prüfphase sowohl einem Komponenten-Test als auch einem Funktionstest unterzogen wird.

9. Verfahren nach einem der Ansprüche 1 bis 8, dadurch gekennzeichnet, daß vor der ersten Prüfung die zu prüfende Baugruppe durch Abtasten einer auf der Baugruppe befindlichen Codierung als deren Kennzeichnung ermittelt und registriert wird und daß das Ergebnis der nachfolgenden Prüfung der registrierten Kennzeichnung der Baugruppe zugeordnet wird.

10. Verfahren nach Anspruch 9, dadurch gekennzeichnet, daß bei Abtastung der Baugruppen-Codierung eine Registrierung der jeweiligen Baugruppen-Kennzeichnung im Speicher eines Rechners erfolgt, daß jedes Prüfungsergebnis einer als ordnungsgemäß ermittelten Prüfung der jeweiligen Baugruppe bis zum Erreichen der Ausgabevorrichtung der gespeicherten Baugruppen-Kennzeichnung zugeordnet wird und daß bei Ermittlung einer nichtordnungsgemäßen Baugruppe die Prüfung abgebrochen und das Prüfungsergebnis ebenfalls der Baugruppen-Kennzeichnung im Speicher des Rechners zugeordnet wird.

11. Verfahren nach Anspruch 10, dadurch gekennzeichnet, daß bei Ermittlung einer nichtordnungsgemäßen Baugruppe die Fehlerursache analysiert wird und die Baugruppe, gegebenenfalls nach einer Instandsetzung an die den Fehler verursachende Verarbeitungsstation zurückgeführt und anschließend einer erneuten Prüfung unterzogen wird.

12. Verfahren nach einem der Ansprüche 9 bis 11, dadurch gekennzeichnet, daß die Codierung der jeweiligen Baugruppe vor der ersten Prüfphase ermittelt wird und daß im Falle eines Baugruppen-Defektes die Codierung bei Ausschleusung erneut gelesen und gespeichert wird.

13. Verfahren nach Anspruch 12, dadurch gekennzeichnet, daß die jeweilige Baugruppe nach einer vorgegebenen Anzahl von Ausschleusungen endgültig das Prüfverfahren verläßt.

14. Vorrichtung zum Temperieren und Prüfen von elektronischen, elektromechanischen oder mechanischen Baugruppen, insbesondere Leiterplatten als Halbzeug, deren Bauelemente mittels Bestückungs-Station und sich daran anschließender Lötstation und/oder Verklebungsstation elektrisch leitend und mechanisch fest aufgebracht sind, wobei der Lötstation und/oder Verklebungsstation wenigstens eine Prüfzone mit einem Baugruppen-Transport in Form einer Transportvorrichtung und wenigstens einer Prüfvorrichtung mit Adaptereinrichtung zur elektrischen Verbindung der Baugruppen mit der Prüfvorrichtung nachgeschaltet ist, dadurch gekennzeichnet, daß der Lötstation (1) oder Verklebungsstation wenigstens eine gegenüber der Umgebung atmosphärisch und thermisch zumindest weitgehend isolierte Prüfzone (8, 74) mit Eingangs- und Ausgangsschleusen nachgeschaltet sind, die jeweils wenigstens eine Adaptereinrichtung (4, 5, 6) und/oder optischer Strahlungsprüfeinrichtung zum Anschluß der Baugruppe an die Prüfstation (7, 8, 9) aufweisen, wobei wenigstens eine Prüfzone auf eine Temperatur im Bereich von -50 bis 200°C einstellbar ist, und wobei die Prüfstation an ihrem Signalausgang mit einem Stellglied zur Aussortierung von fehlerhaften Baugruppen in Richtung einer Ausgabevorrichtung für einwandfreie Baugruppen oder in Richtung von Ausgangsschleusen zum Austritt defekter Baugruppen aus der Prüfzone verbunden ist.

15. Vorrichtung nach Anspruch 14, dadurch gekennzeichnet, daß der Lötstation (1) oder Verklebungsstation zwei gegenüber der Umgebung atmosphärisch und thermisch zumindest weitgehend isolierte Prüfzonen (2, 3) nachgeschaltet sind, wobei die erste der Prüfzonen auf eine Temperatur im Bereich von 25 bis 200°C einstellbar und die zweite Prüfzone (3) auf eine Temperatur im Bereich von -50 bis +25°C einstellbar ist.

16. Vorrichtung nach Anspruch 14 oder 15, dadurch gekennzeichnet, daß durch das Stellglied ein Austritt defekter Baugruppen aus der Prüfzone einstellbar ist.

17. Vorrichtung nach einem der Ansprüche 14 bis 16, dadurch gekennzeichnet, daß wenigstens die erste der beiden Prüfzonen ein der Prüfvorrichtung vorgeschaltetes Abtastsystem (17) zur Entschlüsselung einer auf der jeweiligen Baugruppe befindlichen Codierung aufweist.

18. Vorrichtung nach Anspruch 17, dadurch gekennzeichnet, daß das Abtastsystem (17, 18, 43) jeweils mit wenigstens einem Eingang eines digitalen Rechners verbunden ist, daß die Prüfstation (9, 12, 27) jeweils mit wenigstens einem Eingang und wenigstens einem Steuer-Ausgang des Rechners und daß die Transportvorrichtung (6) mit wenigstens einem Steuer-Ausgang des Rechners verbunden ist.
